# EUROPÄISCHE PATENTANMELDUNG

(11) **EP 1 008 914 A2**
(43) Veröffentlichungstag der Anmeldung: **14.06.2000**
(21) Anmeldenummer: 99121714.2
(22) Anmeldetag: 03.11.1999
(51) Int. Cl.: G03F 7/20

(54) **Projektions-Mikrolithographiegerät**

(30) Priorität: 08.12.1998 DE 19856575
(71) Anmelder: Carl Zeiss, 89518 Heidenheim (Brenz) (DE); CARL-ZEISS-STIFTUNG, trading as CARL ZEISS, 89518 Heidenheim (DE)
(72) Erfinder: Von Bünau, Rudolf, 89518 Heidenheim (DE); Schultz, Jörg, 73430 Aalen (DE); Wangler, Johannes, 89551 Königsbronn (DE)
(74) Vertreter: Ostertag, Ulrich

(57) **Zusammenfassung**

Ein Projektions-Mikrolithographiegerät umfaßt in seiner Beleuchtungseinrichtung in an und für sich bekannter Weise neben einer Lichtquelle und einem Objektiv eine eine besondere Bildfeldform erzeugende Einrichtung. Diese Bildfeldform genügt vorzugsweise den folgenden Bedingungen: Zum einen umfaßt sie Felder (1 bis 4), die in Richtung der Scan-Bewegung (y-Richtung) zumindest bereichsweise durch einen freien Bereich voneinander getrennt sind und die in einer eine Rotationssymmetrie zumindest grob annähernden Weise im Randbereich des zirkularen Bildfeldes (5) des nachgeschalteten Projektionsobjektives liegen. Darüber hinaus muß das Integral der Menge des die der Felder (1 bis 4) durchtretenden Lichtes in Scan-Richtung über die gesamte Erstreckung der Bildfeldform in der zur Scan-Richtung senkrechten Richtung konstant sein. Eine derartige Bildfeldform (1 bis 4) ersetzt in belichtungstechnich äquivalenter Weise eine herkömmliche rechteckige Scannerschlitzform, deren Breite in Scan-Richtung dem erwähnten Integral bei der erfindungsgemäßen Bildfeldform entspricht. Mit der erfindungsgemäßen Ausgestaltung der Bildfeldform gelingt jedoch eine annähernd rotationssymmetrische Ausleuchtung des Projektionsobjektives, so daß nicht rotationssymmetrische, strahlungsbedingte Abbildungsfehler des Objektives nur vermindert auftreten.

## Beschreibung

Die Erfindung betrifft ein Projektions-Mikrolithographiegerät mit
a) einer Beleuchtungseinrichtung, die ihrerseits umfaßt:
   aa) eine Lichtquelle;
   ab) eine in einer Retikelebene eine Bildfeldform erzeugende Einrichtung;
b) einem Retikelhalter, der zur Aufnahme eines Retikels in der Retikelebene ausgebildet und in einer Scan-Richtung (y-Richtung) verfahrbar ist;
c) einem Projektionsobjektiv, welches das Muster des in der Retikelebene liegenden Retikels auf eine Waferebene wirft.

Bei derartigen Projektions-Mikrolithographiegeräten werden die einzelnen Chips auf dem unter dem Projektionsobjektiv liegenden Halbleiterwafer nicht vollflächig sondern in einer Scan-Bewegung belichtet, wobei sowohl der Retikelhalter als auch der Waferhalter mit im allgemeinen konstanter Geschwindigkeit und synchronisiert zueinander in einer Richtung linear bewegt werden, die Scan-Richtung oder y-Richtung genannt wird. Um bei möglichst kleinen Objektivdurchmessern eine möglichst große Abmessung des Projektionsbildes in zur Scan-Richtung senkrechter Richtung (x-Richtung) zu erzielen, werden im allgemeinen Bildfeldformen eingesetzt, die rechteckige Schlitze sind. Die Schmalseite dieser Rechtecke verläuft dabei in Scan-Richtung.

Es ist bekannt, daß die rechteckige Schlitzform, mit welcher die Linsen des Projektionsobjektives nicht rotationssymmetrisch ausgeleuchtet werden, durch Linsenerwärmung und/oder Compaction zu nicht rotationssymmetrischen Abbildungsfehlern des Projektionsobjektives führt. Zur Beseitigung und Kompensation dieser nicht rotationssymmetrischen Abbildungsfehler wurde eine Vielzahl von Stoßrichtungen eingeschlagen, deren Grundgedanke immer derselbe ist: Durch eine ebenfalls nicht rotationssymmetrische Maßnahme, die zu den nicht rotationssymmetrischen Abbildungsfehlern des Projektionsobjektives komplementär ist, sollten die Abbildungseigenschaften des Projektionsobjektives symmetrisiert werden. Zu derartigen Maßnahmen zählen die nicht rotationssymmetrische Beheizung oder Kühlung oder auch mechanische Verformung von Linsen. Abgesehen davon, daß die nachträgliche Kompensation nicht rotationssymmetrischer Abbildungsfehler nicht immer optimal gelingt und häufig mit schwer beherrschbaren zeitlichen Verläufen einhergeht, bedeutet die nachträgliche Kompensation regelmäßig einen erheblichen zusätzlichen apparativen Aufwand und entsprechende Kosten.

Ein Beispiel für ein gattungsgemäßes Projektions-Mikrolithographiegerät, welches durch zusätzliche Maßnahmen nicht rotationssymmetrische Abbildungsfehler zu kompensieren sucht, findet sich in der EP 0 823 662 A. Hier wird durch das Projektionsobjektiv zusätzlich zu dem Belichtungszwecken dienenden Licht aus weiteren Lichtquellen zusätzliches Licht hindurchgeschickt, welches die Durchstrahlung der Linsen des Objektives insgesamt symmetrisiert, sich jedoch zur Belichtung des Wafers nicht eignet bzw. an dieser nicht teilnimmt. Ganz offensichtlich bedeuten die zusätzlichen Lichtquellen und die zur Einbringung in das Projektionsobjektiv erforderlichen optischen Komponenten einen erheblichen Kostenaufwand; darüber hinaus wird das Projektionsobjektiv einer zusätzlichen, unnötigen Wärmebelastung ausgesetzt.

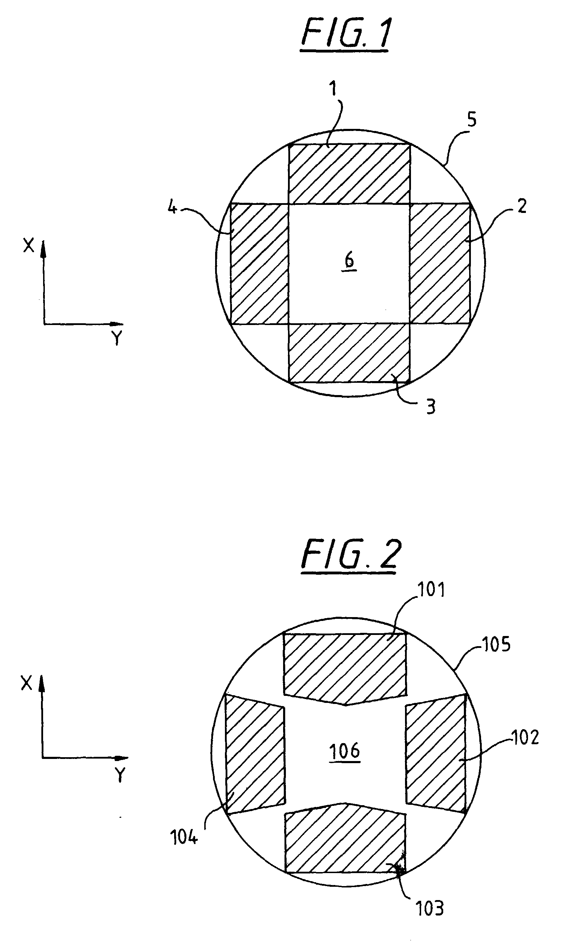

Auch die US-PS 54 73 410 beschreibt ein Projektions-Mikrolithographiegerät der eingangs genannten Art. Hier sind in den Figuren 2A und 2B Bildfeldformen dargestellt, die die Form eines regelmäßigen Sechseckes aufweisen. Diese Bildfeldform haben dort folgenden Sinn: Um den Projektionsobjektivdurchmesser klein halten zu können, werden die Chips auf dem Wafer in y-Richtung nicht in einem einzigen Scan-Vorgang sondern in mehreren parallel zueinander durchgeführten Scan-Vorgängen belichtet ("stitching"-Verfahren). Um Belichtungs-Inhomogenitäten an den parallel zur Scan-Richtung verlaufenden Rändern der so erzeugten "Belichtungsstreifen" zu vermeiden, verlaufen die Begrenzungslinien der Bildfeldform in Scan-Richtung nicht parallel sondern schräg zu dieser. Ein Übergangsbereich zwischen benachbarten "Belichtungsstreifen" wird daher bei zwei aufeinanderfolgenden Scan-Vorgängen überlappend belichtet. Konkret wird zu diesem Zweck die erwähnte Form eines regelmäßigen Sechseckes für die Bildfeldform gewählt. Ein in der US-PS 54 73 410 nicht erkannter Nebeneffekt dieser Bildfeldform ist allerdings, daß die Ausleuchtung des Projektionsobjektives annähernd rotationssymmetrisch erfolgt und daher nicht rotationssymmetrische Abbildungsfehler von vornherein nicht oder nur in geringem Umfange auftreten. Die beschriebene Bildfeldform eignet sich jedoch nur für "Stitching" mit überlappender Belichtung.

Bekannt sind auch "Scanner" mit katadioptrischen oder katoptrischen Objektiven, die wegen der Strahlabschattung der Spiegel und in Anpassung an die Zone bester Bildkorrektur einen außeraxialen Ringsektor abbilden. Hier stellt sich ebenso wie bei sogenannten "Steppern", die mit quadratischen Bildfeldformen arbeiten, das hier behandelte Problem der asymmetrischen Linsenerwärmung nicht.

Aufgabe der vorliegenden Erfindung ist es, ein Projektions-Mikrolithographiegerät der eingangs genannten Art derart auszugestalten, daß strahlungsbedingte, nicht rotationssymmetrische Abbildungsfehler des Projektionsobjektives von vornherein weitestgehend vermieden werden und jeder einzelne Chip auf dem Wafer in einem einzigen Scan-Vorgang der etablierten Art belichtet werden kann.

Diese Aufgabe wird erfindungsgemäß mit den im Anspruch 1 bzw. im Anspruch 2 bzw. im Anspruch 3 angegebenen Mitteln gelöst.

Die Erfindung beruht auf der Erkenntnis, daß unter Beibehaltung eines Aspektverhältnisses, welches für eine klassische rechteckige Schlitzform gilt, eine Bildfeldform erreicht werden kann, die näher in dem Umfangsbereichen des zirkularen korrigierten Bildfeldes liegt, so daß die Wärmeabfuhr erleichtert und auf diese Weise wärmeinduzierte Abbildungsfehler im Projektionsobjektiv reduziert werden können.

Eine besonders bevorzugte Ausführungsform der Erfindung zeichnet sich dadurch aus, daß
e) die die Bildfeldform erzeugende Einrichtung so ausgebildet ist, daß die Bildfeldform folgenden Bedingungen genügt:
   ea) sie umfaßt Felder, die in y-Richtung zumindest bereichsweise durch ein freies Feld voneinander getrennt und in einer eine Rotationssymmetrie zumindest grob annähernden Weise im Randbereich des zirkularen Bildfeldes des Projektionsobjektives liegen;
   eb) das Integral der Menge des die Felder durchtretenden Lichtes in y-Richtung ist über die gesamte Erstreckung der Bildfeldform in der zur y-Richtung senkrechten Richtung (x-Richtung) konstant.

Mit dieser Ausführungsform der Erfindung wird erstmals das bisher durchgängig verwirklichte Prinzip verlassen, wonach die Bildfeldform eine zusammenhängende Fläche sein muß. Es wird erkannt, daß die belichtungstechnische Wirkung eines schmalen Scannerschlitzes äquivalent auch durch eine Mehrzahl von Feldern ersetzt werden kann, die nicht mehr unmittelbar zusammenhängen sondern so im Randbereich des zirkularen korrigierten oder korrigierbaren Bildfeldes des Projektionsobjektives verteilt sind, daß sie der Rotationssymmetrie näherkommen als ein schmaler Rechteckschlitz. Die Korrektur des Objektivs kann dann auch die ungenutzten Bereiche vernachlässigen. Diese zumindest grob angenäherte Rotationssymmetrie verhindert von vornherein, also ohne kompensatorische Maßnahme, strahlungsbedingte nicht rotationssymmetrische Abbildungsfehler des Projektionsobjektives. In ihrer Belichtungswirkung entspricht die erfindungsgemäße Bildfeldform jedoch dem schmalen bekannten Scannerschlitz, weil das Integral der in y-Richtung gemessenen Lichtmenge in den Feldern, aus denen die Bildfeldform zusammengesetzt ist, über die gesamte Erstreckung der Bildfeldform in x-Richtung konstant, nämlich gleich der Breite des konventionellen Schlitzes, ist. Ein Nachteil der erfindungsgemäßen Bildfeldform ist, daß eine geringfügig größere Scanbewegung des Retikelhalters und des Waferhalters ("Overscan") erforderlich ist, da die erfindungsgemäßen Bildfeldformen in y-Richtung eine größere Gesamtabmessung als ein herkömmlicher schmaler Scannerschlitz aufweisen.

Ist die Ausleuchtung homogen, so ist ein "konstantes Integral der Lichtmenge" in y-Richtung sehr einfach durch ein konstantes Integral der Abmessung der Felder in y-Richtung zu realisieren.

In den Unteransprüchen 5 bis 11 sind Ausführungsbeispiele von Bildfeldformen beschrieben, die den oben erwähnten Zweck erfüllen und sich im allgemeinen mit relativ einfachen Beleuchtungseinrichtungen erzielen lassen.

Die Unteransprüche 12 bis 20 betreffen die Ausgestaltung einer derartigen Beleuchtungseinrichtung, die sich eng an bereits vorhandene Beleuchtungseinrichtungen anlehnt, also eine verhältnismäßig geringfügige Modifikation dieser bereits vorhandenen Einrichtungen mit sich bringt. Sie macht von einem oder mehreren Glasstäben als Homogenisierer Gebrauch in einer Weise, die der in der US-PS 5 473 408 beschriebenen ähnelt. Dies ist verhältnismäßig kostengünstig und eröffnet zudem die Möglichkeit der Nachrüstung bereits vorhandener Geräte.

Gleiches gilt für die in den Ansprüchen 21 und 22 angegebenen Mittel, mit denen eine weitgehend verlustfreie, homogene Ausleuchtung der Glasstäbe gelingt, aus denen die die Bildfeldform erzeugende Einrichtung nach den Ansprüchen 12 bis 20 besteht.

Die Ansprüche 23 und 24 betreffen die Ausgestaltung der die Bildfeldform erzeugenden Einrichtung mit einem Prismen-Wabenkondensor, ebenfalls eine preiswerte Möglichkeit, die sich nachrüsten läßt.

Ausführungsbeispiele der Erfindung werden nachfolgend anhand der Zeichnung näher erläutert; es zeigen
- Figur 1: schematisch eine erste Bildfeldform zur Beleuchtung des Retikels in einem Projektionsbelichtungsgerät;
- Figur 2: eine Abwandlung der in Figur 1 dargestellten Bildfeldform;
- Figur 3: schematisch eine Beleuchtungseinrichtung, mit welcher die Bildfeldformen der Figuren 1 und 2 erzeugt werden können;
- Figur 4 bis Figur 6: Ausführungsformen von Glasstabanordnungen, die in der Beleuchtungseinrichtung von Figur 3 verwendet werden können;
- Figur 7: die Einheitszelle der optisch aktiven Struktur eines diffraktiven optischen Elementes, welches in der Beleuchtungseinrichtung von Figur 3 verwendet wird;
- Figur 8: die optisch aktive Struktur des diffraktiven optischen Elementes, die sich aus Einheitszellen nach Figur 4 zusammensetzt;
- Figur 9 bis Fig. 12: weitere Ausführungsformen von Bildfeldformen, wie sie statt der Bildfeldform der Figuren 1 und 2 verwendet werden können;
- Figur 13: ein zweites Ausführungsbeispiel einer Beleuchtungseinrichtung mit einem Prismen-Wabenkondensor;
- Figuren 14 und 15: zwei Anordnungen von Feldwaben, wie sie sich in dem Prismen-Wabenkondensor von Figur 13 finden können.

In Figur 1 stellen die schraffierten Felder 1, 2, 3, 4 zusammen eine Bildfeldform dar, welche zur Beleuchtung des Retikels in einem Projektions-Mikrolithographiegerat verwendet wird. Dieses Retikel wird in Richtung der y-Achse des eingezeichneten rechtwinkligen Koordinatensystemes mit kontinuierlicher Geschwindigkeit bewegt, wie dies für einen "Scan-Vorgang" typisch ist. Die Gesamterstreckung des Bildfeldforms in Richtung senkrecht zur Scan-Richtung, also in x-Richtung, ist so groß, daß bei einem einzigen Scan-Vorgang die vollständige Struktur eines oder mehrerer Chips belichtet wird, daß also zur vollständigen Belichtung der Chip-Struktur nicht mehrere parallel geführte Scan-Vorgänge erforderlich sind.

Die gesamte die Felder 1 bis 4 umfassende Bildfeldform liegt innerhalb des zirkularen korrigierten Bildfeldes des nachgeschalteten Projektionsobjektivs; die kreisförmige Begrenzungslinie dieses zirkularen korrigierten Bildfeldes trägt das Bezugszeichen 5.

Die in Figur 1 dargestellte Bildfeldform entspricht in der Belichtungsfunktion einem herkömmlichen Schlitz mit einem Aspektverhältnis von 2 : 1. Alle vier Felder 1, 2, 3, 4 werden von Rechtecken gebildet, die ihrerseits dasselbe Aspektverhältnis 2 : 1 aufweisen. Sie sind mit ihren zum Mittelpunkt des zirkularen korrigierten Bildfeldes weisenden Seiten so aneinander angelegt, daß sie ein freies quadratisches mittleres Feld 6 umschließen. Die Anordnung der Felder 1 bis 4 ist somit so, daß eine vierzählige Rotationssymmetrie bezüglich der in Figur 1 senkrecht zur Zeichenebene verlaufenden Mittelachse des zirkularen korrigierten Bildfeldes des Projektionsobjektives vorliegt. Gleichzeitig besteht eine doppelte Spiegelsymmetrie zu den Mittellinien der Figur 1, die parallel zur y- und x-Achse verlaufen.

Für die in Figur 1 dargestellte Bildfeldform ist leicht ersichtlich, daß über ihre gesamte Erstreckung in x-Richtung hinweg die integrierte Abmessung in y-Richtung, also die Summe der Abmessungen der einzelnen Felder 1, 2, 3, 4 in y-Richtung, konstant ist: Bewegt man sich in Figur 1 von unten nach oben, so ist diese integrierte Abmessung zunächst einfach gleich der Abmessung des Feldes 3 in y-Richtung. In dem sich weiter oben anschließenden Bereich der Bildfeldform sind die beiden Felder 4 und 2 zu berücksichtigen. Da diese in y-Richtung jeweils die Hälfte der Abmessung des Feldes 3 aufweisen, ist die integrierte Abmessung der Bildfeldform im Bereich der Felder 4, 2 dieselbe wie im Bereich des Feldes 3. In dem sich weiter nach oben in Figur 1 anschließenden Bereich des Feldes 1 liegen wieder dieselben Verhältnisse wie im untersten Bereich des Feldes 3 vor.

Figur 1 kann auch so verstanden werden, daß die innerhalb des leergelassenen, mittleren Feldes 6 liegenden Bereiche eines konventionellen Schlitzes mit Aspektverhältnis 2 : 1 symmetrisch "nach außen geklappt" wurden. Diese Betrachtung macht besonders deutlich, daß mit der in Figur 1 dargestellten Bildfeldform grundsätzlich dieselben Belichtungsergebnisse auf dem Chip erzielt werden können wie durch den konventionellen rechteckigen Schlitz, aus dem die Bildfeldform von Figur 1 hervorgegangen ist.

Durch die in Figur 1 gegenüber einem rechteckigen Schlitz vorgenommene Modifikation wird die Bildfeldform "symmetrisiert": Es entsteht zwar keine vollständige Rotationssondern, wie erwähnt, nur eine vierzählige Symmetrie. Die hierdurch noch eintretenden nicht rotationssymmetrischen wärmeinduzierten Abbildungsfehler des Projektionsobjektives sind jedoch um ein Erhebliches kleiner als bei der rechteckigen Ausführung der Schlitzform. Zudem ist die Wärmeabführung erleichtert, da gerade das mittlere Feld 6, aus dem die Wärmeabfuhr besonders problematisch ist, nicht durchstrahlt wird.

Bei der in Figur 1 dargestellten Bildfeldform überlappen die Felder 1 bis 4 in x-Richtung nicht mit in x-Richtung benachbarten Feldern. Sind die Felder 1 bis 4 nicht in x-Richtung sehr exakt begrenzt und positioniert, können sich daher an den "Stoßstellen" der drei nebeneinanderliegenden Streifen, die auf dem Chip durch die Felder 1 bis 4 belichtet werden, Inhomogenitäten ergeben. Diese Probleme werden mit der geringfügigen Modifikation der Bildfeldform vermieden, die in Figur 2 dargestellt ist.

Die Grundanordnung dieser zweiten Bildfeldform stimmt weitgehend mit derjenigen von Figur 1 überein: Auch hier sind vier Felder, 101, 102, 103, 104 vorgesehen, die in der Mitte ein Feld 106 freilassen. Die Felder 101 bis 104 der Bildfeldform sind jedoch nunmehr nicht mehr exakte Recktecke; ebenso wenig ist das mittlere, freigelassene Feld 106 ein exaktes Quadrat. Durch geringfügige Modifikation von Rechteckformen, die in Figur 2 gestrichelt eingezeichnet sind, entstehen für die Felder 101 bis 104 vielmehr folgende Formen:

Die sich mit ihrer längeren Abmessung in x-Richtung erstreckenden Felder 102 und 104 besitzen die Form gleichschenkliger Trapeze, wobei die kürzere der beiden parallelen Begrenzungslinien zum mittleren Feld 106 hinweist. Diese Felder 102 und 104 entstehen aus der rechteckigen Grundform durch "Abschneiden" kleiner Dreiecke an den sich in y-Richtung erstreckenden Seiten.

Die sich mit ihrer längeren Abmessung in y-Richtung erstreckenden Felder 101 und 103 besitzen die Form von "Häusern", also die Form von Rechtecken mit angesetzten Dreiecken, wobei die Spitzen der Dreiecke nach innen weisen. Diese Felder 101 und 103 kann man sich entstanden denken durch Abschneiden rechtwinkliger Dreiecke von einem Rechteck, dessen Erstreckung in x-Richtung um die Länge der kleineren Kathete dieser Dreiecke gegenüber den Feldern 1 und 3 von Figur 1 verlängert ist, wie dies durch die gestrichelten Linien in Figur 2 angedeutet ist.

Man kann sich das Zustandekommen der Felder 101 und 103 jedoch auch so vorstellen: Die von den seitlichen Felder 102, 104 abgeschnittenen Dreiecke werden durch Parallelverschiebung in Richtung der positiven bzw. negativen y-Achse an die Rechtecke der Felder 1 und 3 von Figur 1 angelegt. Die letztere Betrachtungsweise macht deutlicher, daß die Grundbedingung für eine erfindungsgemäße Bildfeldform auch bei dem Ausführungsbeispiel von Figur 2 gewahrt ist, wonach das Linienintegral der Abmessung in y-Richtung über die gesamte Erstreckung in x-Richtung konstant ist: Für die "Grundform" der Figur 1 wurde dies oben schon nachgewiesen. Die Modifikation dieser Grundform entsprechend Figur 2 kann diesbezüglich keine Änderung ergeben, da, wie erwähnt, zur Erzielung des Ausführungsbeispiels von Figur 2 nur Dreiecke der Bildfeldform von Figur 1 in y-Richtung verschoben wurden.

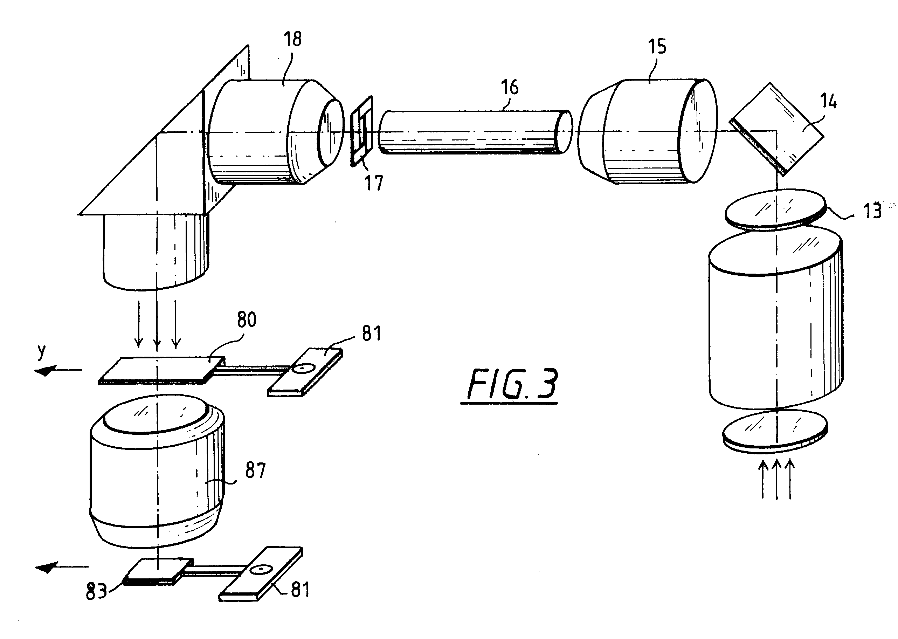

In Figur 3 ist ein Projektions-Mikrolithographiegerät dargestellt, in welchem mit den Bildfeldformen von Figur 1 und Figur 2 gearbeitet werden kann. Der Grundaufbau der Beleuchtungseinrichtung in diesem Gerät ist in der DE 195 20 563 A beschrieben; er wird nachfolgend anhand der Figur 3 nur so weit erläutert, wie dies zum Verständnis der vorliegenden Erfindung erforderlich ist. Wegen Einzelheiten wird auf die DE 195 20 563 A verwiesen.

Der Beleuchtungseinrichtung von Figur 3 ist eine nicht mehr dargestellte Lichtquelle, z.B. ein Laser, vorgeschaltet, deren Lichtstrahlen durch die Pfeile 10 angedeutet sind. Das Licht durchquert ein erstes diffraktives optisches Element 11. Dieses formt die Beleuchtungspupille und liegt hierzu in der Objektebene eines Objektives 12. Wegen Einzelheiten der Ausgestaltung und Funktion dieses ersten diffraktiven optischen Elementes 11 wird auf die oben erwähnte DE 195 20 563 A verwiesen, ebenso hinsichtlich der verschiedenen Linsen, die Teil des Objektives 12 sein können.

In der Austrittspupille des Objektives 12 ist ein zweites diffraktives optisches Element 13 vorgesehen, auf dessen genaue Funktion und nähere Ausgestaltung weiter unten eingegangen wird. Nach dem Durchtritt durch das zweite diffraktive optische Element 13 wird das Licht durch einen planen Umlenkspiegel 14 in eine Einkopplungsoptik 15 geleitet. Diese ist erneut nach dem Stand der Technik ausgestaltet und bedarf daher hier keiner näheren Erläuterung.

Das die Einkopplungsoptik 15 verlassende Licht fällt auf die in Figur 3 linke Stirnseite einer Glasstabanordnung 16, die ebenfalls weiter unten näher beschrieben ist, verläßt diese Glasstabanordnung 16 durch deren rechte Stirnseite und tritt durch eine verstellbare Feldblende 17 ("reticle-masking-system"), wie diese als solche bekannt ist, hier aber vorzugsweise die genaue Feldform gemäß der Erfindung festlegt. Ein nachgeschaltetes Objektiv 18, welches einen planen Umlenkspiegel enthält, bildet die in einer Zwischenfeldebene liegende Feldblende 17 auf dem Retikel 80 ab.

Das Retikel 80 ist mit Hilfe einer "Scanning"-Einrichtung 81 linear in y-Richtung bewegbar.

Das von der Bildfeldform durchstrahlte Muster auf dem Retikel 80 wird durch ein Projektionsobjektiv 82 auf einen Wafer 83 abgebildet, der mit Hilfe einer "Scanning"-Einrichtung synchron zum Retikel 80 in y-Richtung linear bewegt und dabei belichtet werden kann.

Die Glasstabanordnung 16 kann in unterschiedlicher Weise aufgebaut sein.

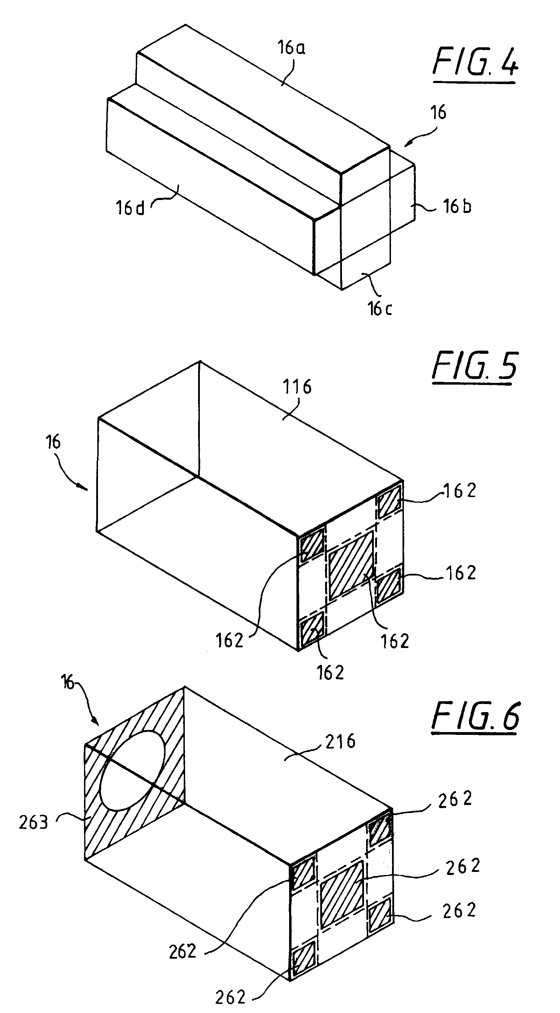

Bei dem in Figur 4 dargestellten Ausführungsbeispiel umfaßt die Glasstabanordnung 16 eine Anordnung aus vier einzelnen Glasstäben 16a bis 16d, deren Querschnittsformen und Anordnung den Formen und der Anordnung der Felder 1 bis 4 im Bildfeldform von Figur 1 geometrisch ähnlich sind. Das heißt, alle Glasstäbe 16a bis 16d weisen einen rechteckigen Querschnitt mit einem Aspektverhältnis von 2 : 1 auf, die so mit ihren Kanten aneinandergelegt sind, daß sie in der Mitte einen freibleibenden, im Querschnitt quadratischen Raum umgeben.

In Figur 5 besteht die Glasstabanordnung 16 aus einem einzigen Glasstab 116 mit großem rechteckigem Querschnitt. Dieser ist an seiner Austrittsstirnseite mit Verspiegelungen 162 versehen, welche zu der angestrebten Bildfeldform (im dargestellten Beispiel zu derjenigen der Figur 1) im wesentlichen komplementär sind. Diese Verspiegelungen 162 dienen als Maske, welche jedoch die Lichtausbeute nur geringfügig beeinträchtigt.

Dieser Gedanke ist beim Ausführungsbeispiel der Glasstabanordnung 16 von Figur 6 konsequent weitergeführt: Diese besteht wie diejenige von Figur 5 aus einem einzigen Glasstab 216 mit den schon beschriebenen Verspiegelungen 262 an der Austrittsstirnseite. Zusätzlich ist hier an der Eintrittsstirnseite eine weitere Verspiegelung 263 vorgesehen. Diese besitzt eine mittlere Aussparung, welche im wesentlichen dem Querschnitt des hier in den Glasstab 216 eintretenden Lichtbündels entspricht. Zwischen den gegenüberliegenden Verspiegelungen 262 und 263 können auf diese Weise Mehrfachreflexionen stattfinden, welche den Lichtverlust vermindern.

Aufgabe des oben kurz schon angesprochenen zweiten diffraktiven optischen Elementes 13 ist es, die Eintritts-Stirnfläche der Glasstabanordnung 16 gleichförmig mit Licht zu füllen. Eine ähnliche Aufgabe erfüllt das zweite diffraktive optische Element der DE 195 20 563 A, wo nur ein einziger rechteckiger Querschnitt eines einziges Glasstabes auszufüllen ist. Dieses läßt sich im wesentlichen unverändert für die Ausleuchtung der Glasstabanordnungen 16 der Figuren 5 und 6 verwenden. Um, wie dies im für die Ausführungsform der Figur 4 erforderlich ist, die Eintritts-Stirnseiten einer komplizierteren Glasstabanordnung 16 aus mehreren Glasstäben 16a bis 16d mit Licht homogen füllen zu können, bedarf die optisch aktive Struktur, die sich auf dem zweiten diffraktiven optischen Element 13 befindet, gegenüber der bekannten einer Modifikation:

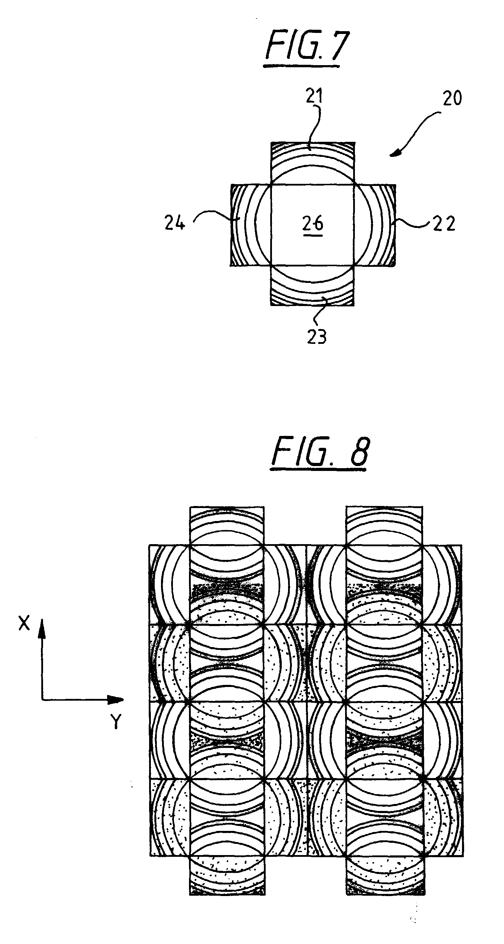

In Figur 7 ist eine "Einheitszelle" der optisch wirksamen Struktur des zweiten diffraktiven optischen Elementes 13 gezeigt. Diese Einheitszelle 20 weist vier Felder 21, 22, 23, 24 auf, die geometrisch ähnlich zur Bildfeldform von Figur 1 jeweils aus Rechtecken mit einem Aspektverhältnis von 2 : 1 bestehen, die so aneinandergelegt sind, daß sie ein mittleres quadratisches Feld 26 einschließen. Nur die den Feldern 1 bis 4 der Bildfeldform von Figur 1 entsprechenden rechteckigen Felder 21 bis 24 der Einheitszelle 20 sind mit optisch aktiven Strukturen versehen. Dabei handelt es sich um konzentrische Kreise, deren Mittelpunkt in der Mitte der Einheitszelle 20 liegt. Die Detailausgestaltung kann diejenige einer Fresnel-Linse oder auch diejenige einer binären diffraktiven Phasenprofil-Linse sein, wie dies näher in der DE 195 20 563 A beschrieben ist.

Aus der in Figur 4 dargestellten "Einheitszelle" 20 wird die auf dem zweiten diffraktiven optischen Element 13 angebrachte "makroskopische" optisch aktive Struktur durch mehrfaches Aneinanderfügen gewonnen. Dies ist in Figur 5 dargestellt. Diese zeigt - dunkel schraffiert - eine Mehrzahl von Einheitszellen 20 nach Figur 4, die mit den jeweils nach außen zeigenden Schmalseiten der Felder 21 bis 24 aneinander angelegt sind. Zwischen den so zusammengestellten Einheitszellen 20 bilden sich zunächst freibleibende quadratische Felder, die den in der Mitte der Einheitszelle 20 liegenden Feldern 26 ähneln. Insgesamt entsteht so zunächst eine Anordnung, die dem Muster eines Schachfeldes ähnlich ist. In einem zweiten Schritt wird diesem "Schachfeldmuster" ein zweiter Satz von Einheitszellen 20 so überlagert, daß deren freibleibendes mittleres Feld 26 auf ein "dunkles" Feld des im gedanklichen Zwischenschritt entstandenen Schachbrettmusters gelegt wird. Auf diese Weise ergibt sich die in Figur 5 dargestellte Struktur des zweiten diffraktiven optischen Elementes 13, in der sich keine freien Felder mehr finden.

Das Zustandekommen dieser Struktur kann man sich auch folgendermaßen vorstellen: Auf eine Anordnung einer Vielzahl von Einheitszellen 20, die den in Figur 5 dunkel dargestellten Flächen entspricht, wird nach einer Relativverschiebung in x-Richtung um die Seitenlänge eines Quadrates ein identisches zweites Muster überlagert.

Mit Hilfe des so ausgerüsteten zweiten diffraktiven optischen Elementes 13 gelingt die weitgehend verlustfreie, homogene Ausleuchtung der in Figur 4 linken Stirnseite der Glasstabanordnung 16.

Die im Grundsatz gleiche Beleuchtungseinrichtung kann auch zur Erzielung der in Figur 2 dargestellten, modifizierten Bildfeldform eingesetzt werden. Hierzu werden z. B. die einzelnen Glasstäbe 16a bis 16b in der Glasstabanordnung 16 von Figur 4 geringfügig modifiziert: Sie erhalten nunmehr rechteckige Querschnittsformen, die den in Figur 2 zum Teil gestrichelt ergänzten Rechteckformen entsprechen, aus denen durch Abschneiden von Dreiecken in der geschilderten Weise die dortigen Felder 101, 102, 103, 104 entstanden sind. Das heißt insbesondere, daß die beiden gegenüberliegenden Glasstäbe in der Glasstabanordnung 16, welche den Feldern 101 und 103 aus Figur 2 entsprechen, ein Rechteckprofil aufweisen, das in x-Richtung etwas größer als das Rechteckprofil der beiden anderen Glasstäbe, welche den Feldern 102 und 104 von Figur 2 entsprechen, in y-Richtung ist. Die vier Glasstäbe sind dann auch nicht mehr Kante an Kante aneinander angelegt sondern überlappen einander geringfügig in x-Richtung. Eine zusätzliche Blende nahe der Ebene des Ausgangs der Glasstabanordnung 16 bewerkstelligt das Abschneiden der unerwünschten Dreiecksbereiche. Hiermit ist zwar ein geringer, jedoch insgesamt noch hinnehmbarer Lichtverlust verbunden.

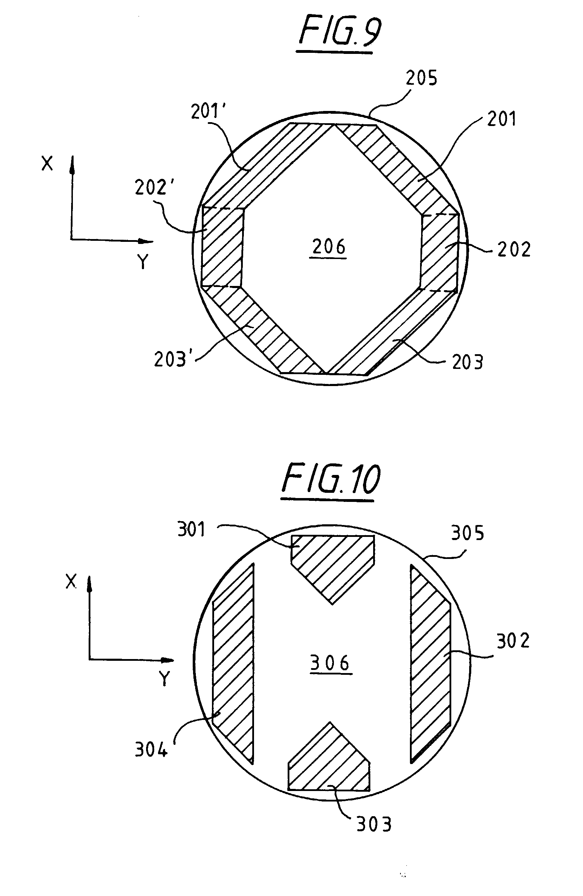

Figur 9 zeigt eine dritte Bildfeldform, welche bei einem Projektions-Mikrolithographiegerät statt der Bildfeldformen der Figuren 1 und 2 zum Einsatz kommen kann. Diese Bildfeldform ist ebenfalls spiegelsymmetrisch zu aufeinander senkrecht stehenden Mittellinien, die parallel zur y- und x-Achse sind, weist jedoch nur noch eine zweizählige Rotationssymmetrie um eine senkrecht zur Zeichenebene von Figur 6 verlaufende Mittelachse auf. Diese polygonförmige Bildfeldform läßt sich in folgender Weise aus sechs Feldern zusammengesetzt denken:

Ein erstes Feld 201 hat die Form eines Parallelogramms, dessen schmale Seiten eine Länge haben, die der Hälfte der Schmalseite eines konventionellen rechteckigen Scannerschlitzes entspricht, welches dieselbe Belichtungswirkung hervorruft. An die in Figur 9 gestrichelt dargestellte und nur gedachte Schmalseite des Feldes 201 ist ein zweites, rechteckiges Feld 202 nahtlos angesetzt. Das Feld 202 geht über seine untere, ebenfalls gestrichelte und gedachte Begrenzungslinie in ein weiteres parallelogrammförmiges Feld 203 über, welches zu dem Feld 201 bezüglich der in y-Richtung laufenden Symmetrieachse symmetrisch ist.

Spiegelsymmetrisch zu der parallel zur x-Achse verlaufenden Mittellinie sind weitere Felder 204, 205, 206 vorgesehen, wobei an dieser Mittellinie die jeweils benachbarten Felder 206 und 201 bzw. 204 und 203 nur mit ihren Ecken aneinanderstoßen.

Es ist leicht einzusehen, daß die in Figur 9 dargestellte Bildfeldform die Grundbedingung der vorliegenden Erfindung erfüllt, nach welcher das Linienintegral der Abmessungen in y-Richtung über die Gesamterstreckung in x-Richtung konstant sein muß.

Derselben Grundbedingung genügt offensichtlich auch die Bildfeldform von Figur 10. Diese umfaßt vier Felder 301, 302, 303, 304, die sich an keiner Stelle gegenseitig berühren. Ähnlich wie bei der Bildfeldform von Figur 2 sind die in Figur 10 in x-Richtung voneinander am weitesten entfernten Felder 301 und 303 "hausförmig", sind also aus einem Rechteck und einem mit der Spitze zur Mitte des Bildfeldforms weisenden Dreieck zusammengesetzt. Die Abmessung der Felder 301 und 303 in y-Richtung entspricht der Breite eines konventionellen rechteckförmigen Scannerschlitzes, welcher dieselbe Belichtungswirkung hervorruft.

Die in y-Richtung voneinander am weitesten entfernten Felder 302 und 304 der Bildfeldform von Figur 10 sind, ähnlich wie die Felder 102 und 104 von Figur 2, als gleichseitige Trapeze ausgestaltet. Während aber beim Ausführungsbeispiel von Figur 2 die kürzeren der beiden parallelen Begrenzungslinien der Trapeze nach innen weisen, ist dies beim Ausführungsbeispiel von Figur 10 umgekehrt: Die kürzeren der beiden parallelen Begrenzungslinien liegen außen. Dies hat den Vorteil, daß die trapezförmigen Felder 302 und 304 näher an den Rand 305 des zirkularen korrigierten Bildfeldes herangeführt werden können. Auf das Linienintegral der Abmessungen der Felder 302 und 304 in y-Richtung hat diese andere Anordnung der trapezförmigen Felder 302 und 304 offensichtlich keinen Einfluß.

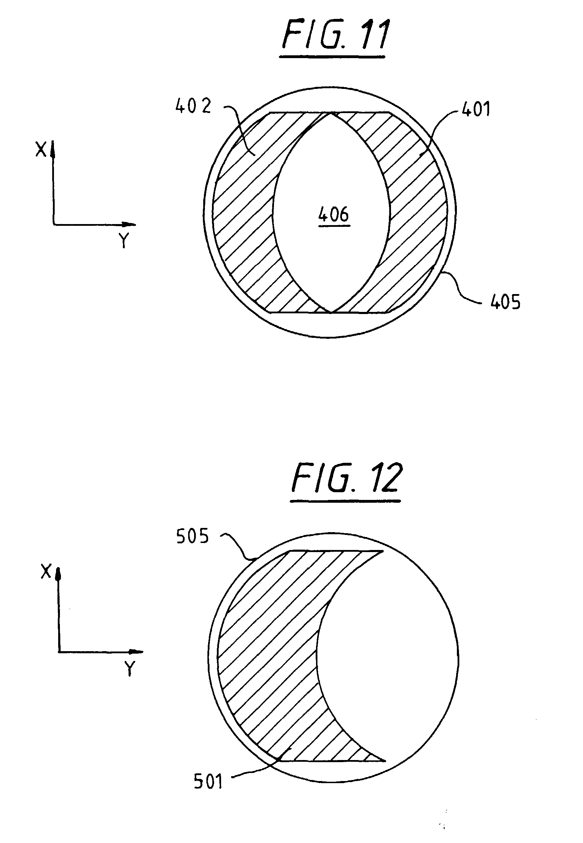

Die in Figur 11 dargestellte Bildfeldform weist wiederum eine Spiegelsymmetrie zu der parallel zur x-Richtung verlaufenden Mittellinie auf. Sie umfaßt zwei Felder 401, 402, die grob die Form eines Kreisringsegmentes aufweisen. Die kreisbogenförmigen Begrenzungslinien sind jedoch nicht konzentrisch; vielmehr weisen beide Kreisbogenlinien denselben Radius auf, wobei allerdings die Mittelpunkte in y-Richtung einen Abstand voneinander aufweisen. Auf diese Weise wird erreicht, daß die kreisringsegmentähnlichen Felder 401 und 402 in y-Richtung gesehen jeweils unabhängig von der x-Richtung immer dieselbe Abmessung aufweisen. Diese Abmessung in y-Richtung entspricht der Hälfte der Breite eines äquivalenten konventionellen rechteckigen Schlitzes.

Die in Figur 12 dargestellte Bildfeldform umfaßt nur ein einziges kreisringsegmentähnliches Feld 501. Auch dieses ist an zwei gegenüberliegenden Seiten durch Kreisbögen mit demselben Radius begrenzt, deren Mittelpunkte in y-Richtung einen Abstand voneinander aufweisen. Dieser Abstand entspricht in diesem Falle der Breite eines äquivalenten konventionellen rechteckigen Schlitzes.

Die in Figur 12 dargestellte Ausführungsform der Bildfeldform ist zwar nicht besonders rotationssymmetrisch; die vom Licht durchtretenen Bereiche liegen jedoch näher am Umfang des zirkularen korrigierten Bildfeldes 505, so daß die Wärmeabfuhr aus dem Projektionsobjektiv erleichtert ist und aus diesem Grunde geringere erwärmungsbedingte Abbildungsfehler im Projektionsobjektiv auftreten.

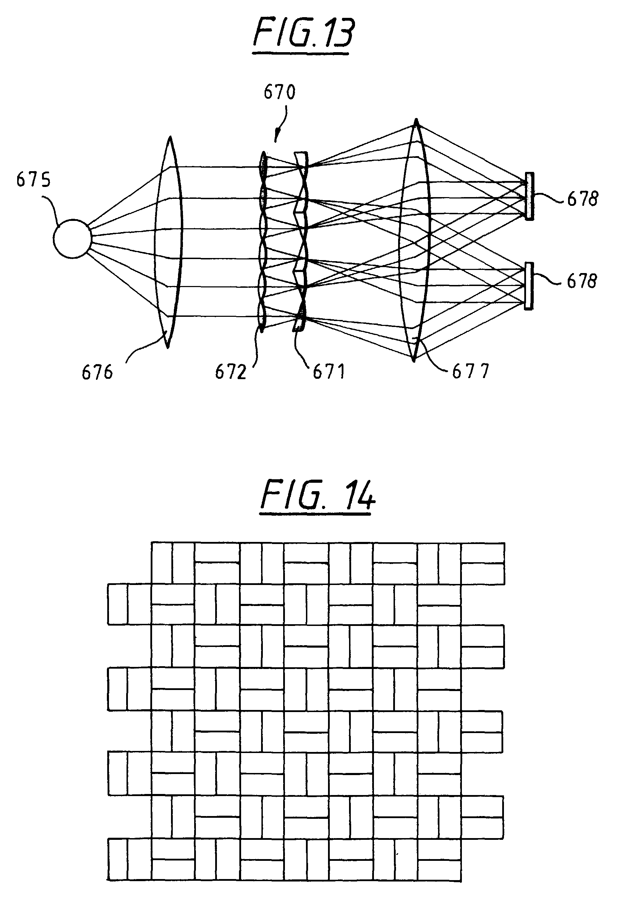

Figur 13 zeigt eine alternative Möglichkeit der Einrichtung, welche die gewünschte Bildfeldform erzeugt. In Figur 13 wird das von einer Lichtquelle 675 ausgehende Licht durch eine Kollektorlinse 676 parallelisiert und durchtritt sodann einen Prismen-Wabenkondensor 670. Der grundsätzliche Aufbau eines derartigen Wabenkondensors ist bekannt. Er umfaßt an der Eintrittsseite eine Anordnung von Feldwaben 672 sowie an der Austrittsseite eine Anordnung von Pupillenwaben 671 derart, daß die einzelnen Waben aus dem einfallenden parallelen Licht eine Vielzahl von in unterschiedlichen Richtungen austretenden Lichtbündeln erzeugen. Diese Lichtbündel werden sodann durch eine Feldlinse 677 auf dem Retikel 678 so abgebildet, daß zumindest in einer ersten Annäherung dort die gewünschte, im dargestellten Ausführungsbeispiel geteilte Bildfeldform entsteht.

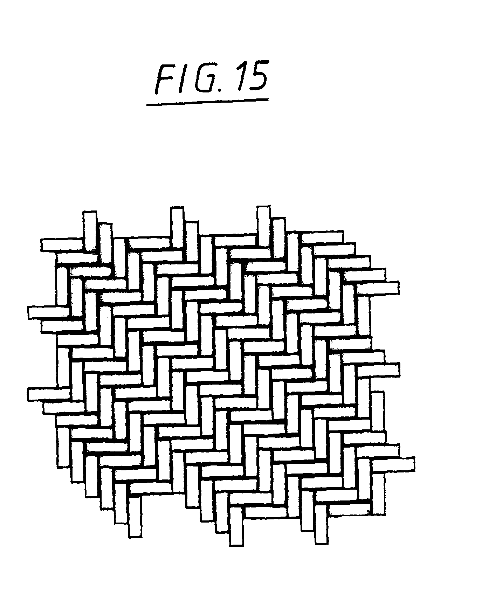

Anordnungen von Feldwaben, mit denen dieses Ergebnis erreicht werden können, sind in den Figuren 14 und 15 dargestellt.

Durch die - wenn auch teilweise noch recht grobe - Annäherung der Bildfeldform der oben beschriebenen Bildfeldformen an eine Rotationssymmetrie werden die optischen Komponenten des Projektionsobjektives in weit geringerem Maße unsymmetrisch ausgeleuchtet als mit den bekannten schmalen Scannerschlitzen. Die Folge ist, daß das Auftreten von nicht rotationssymmetrischen thermisch oder strahlungsbedingten Abbildungsfehlern im Projektionsobjektiv weitgehend unterdrückt werden kann, ohne hierfür Eingriffe in die Konstruktionsprinzipien des Projektionsobjektives und nicht überschaubare Veränderungen der Beleuchtungseinrichtung vornehmen zu müssen.

## Patentansprüche

1. Projektions-Mikrolithographiegerät mit
a) einer Beleuchtungseinrichtung, die ihrerseits umfaßt:
aa) eine Lichtquelle;
ab) eine in einer Retikelebene eine Bildfeldform erzeugende Einrichtung;
b) einem Retikelhalter, der zur Aufnahme eines Retikels in der Retikelebene ausgebildet und in einer Scan-Richtung (y-Richtung) verfahrbar ist;
c) einem Projektionsobjektiv, welches das Muster des in der Retikelebene liegenden Retikels auf eine Waferebene wirft;
dadurch gekennzeichnet, daß
d) die die Bildfeldform erzeugende Einrichtung (16; 670) so ausgebildet ist, daß eine Bildfeldform entsteht, welche das zirkulare korrigierte Bildfeld (5; 105; 305; 405; 505) im Mittelbereich abschattet.

2. Projektions-Mikrolithographiegerät mit
a) einer Beleuchtungseinrichtung, die ihrerseits umfaßt:
aa) eine Lichtquelle;
ab) eine in einer Retikelebene eine Bildfeldform erzeugende Einrichtung;
b) einem Retikelhalter, der zur Aufnahme eines Retikels in der Retikelebene ausgebildet und in einer Scan-Richtung (y-Richtung) verfahrbar ist;
c) einem Projektionsobjektiv, welches das Muster des in der Retikelebene liegenden Retikels auf eine Waferebene wirft;
dadurch gekennzeichnet, daß
d) die die Bildfeldform erzeugende Einrichtung (16; 670) so ausgebildet ist, daß eine Bildfeldform entsteht, welche an einen zur optischen Achse konzentrischen Kreisring besser angenähert ist als jedes Recht-. eck.

3. Projektions-Mikrolithographiegerät mit
a) einer Beleuchtungseinrichtung, die ihrerseits umfaßt:
aa) eine Lichtquelle;
ab) eine in einer Retikelebene eine Bildfeldform erzeugende Einrichtung;
b) einem Retikelhalter, der zur Aufnahme eines Retikels in der Retikelebene ausgebildet und in einer Scan-Richtung (y-Richtung) verfahrbar ist;
c) einem Projektionsobjektiv, welches das Muster des in der Retikelebene liegenden Retikels auf eine Waferebene wirft;
dadurch gekennzeichnet, daß
d) die die Bildfeldform erzeugende Einrichtung (16; 670) so ausgebildet ist, daß eine Bildfeldform entsteht, die durch eine flächentreue und in Richtung der langen Rechteckseite längentreue Abbildung aus einem Rechteck mit einer langen und mit einer kurzen Rechteckseite mit einem Aspektverhältnis von größer als 1,5 hervorgeht und mindestens zwei geschlossene Kurven als Rand aufweist.

4. Projektions-Mikrolithographiegerät nach mindestens einem der Ansprüche 1 bis 3, dadurch gekennzeichnet, daß
e) die die Bildfeldform (1, 2, 3, 4; 101, 102, 103, 104; 201, 202, 203, 204, 205, 206; 301, 302, 303, 304) erzeugende Einrichtung (16) so ausgebildet ist, daß die Bildfeldform (1, 2, 3, 4; 101, 102, 103, 104; 201, 202, 203, 204, 205, 206; 301, 302, 303, 304) folgenden Bedingungen genügt:
ea) sie umfaßt Felder (1, 2, 3, 4; 101, 102, 103, 104; 201, 202, 203, 204, 205, 206; 301, 302, 303, 304), die in y-Richtung zumindest bereichsweise durch ein freies Feld (6; 106; 206; 306) voneinander getrennt und in einer eine Rotationssymmetrie zumindest grob annähernden Weise im Randbereich des zirkularen Bildfeldes (5; 105; 205; 305) des Projektionsobjektives liegen;
eb) das Integral der die Felder (1, 2, 3, 4; 101, 102, 103, 104; 201, 202, 203, 204, 205, 206; 301, 302 303, 304) durchtretenden Lichtmenge in y-Richtung ist über die gesamte Erstreckung der Bildfeldform in der zur y-Richtung senkrechten Richtung (x-Richtung) konstant.

5. Projektions-Mikrolithographiegerät nach Anspruch 4, dadurch gekennzeichnet, daß das Integral der Abmessungen der Felder (1, 2, 3, 4; 101, 102, 103, 104; 201, 202, 203, 204, 205, 206; 301, 302 303, 304) in y-Richtung über die gesamte Erstreckung der Bildfeldform in der zur y-Richtung senkrechten Richtung (x-Richtung) konstant ist.

6. Projektions-Mikrolithographiegerät nach einem der vorhergehenden Ansprüche, 1, dadurch gekennzeichnet, daß die Bildfeldform (1, 2, 3, 4; 101, 102, 103, 104; 201, 202, 203, 204, 205, 206; 301, 302, 303, 304) zu einer parallel zur x-Richtung verlaufenden Mittellinie achsensymmetrisch ist.

7. Projektions-Mikrolithographiegerät nach einem der vorhergehenden Ansprüche, dadurch gekennzeichnet, daß die Bildfeldform (1, 2, 3, 4; 101, 102, 103, 104; 201, 202, 203, 204, 205, 206; 301, 302, 303, 304) eine mindestens zweizählige Rotationssymmetrie um eine senkrecht zu seiner Ebene stehende Mittelachse aufweist.

8. Projektions-Mikrolithographiegerät nach einem der vorhergehenden Ansprüche, dadurch gekennzeichnet, daß die Bildfeldform vier rechteckige Felder (1, 2, 3, 4) umfaßt, die so aneinander angelegt sind, daß sie ein rechteckiges freies Feld (6) einschließen.

9. Projektions-Mikrolithographiegerät nach Anspruch 8, dadurch gekennzeichnet, daß das rechteckige freie Feld (6) zumindest annähernd ein Quadrat ist und daß die vier Felder (1, 2, 3, 4) zumindest annähernd Rechtecke mit einem Aspektverhältnis von 2 : 1 sind.

10. Projektions-Mikrolithographiegerät nach einem der Ansprüche 1 bis 3, dadurch gekennzeichnet, daß die Bildfeldform eine Mehrzahl von rechteckigen Feldern (202, 205) und/oder parallelogrammförmigen Feldern (201, 203, 204, 206) umfaßt, die polygonartig zusammengefügt sind.

11. Projektions-Mikrolithographiegerät nach einem der vorhergehenden Ansprüche, dadurch gekennzeichnet, daß die Felder (101, 102, 103, 104; 301, 302, 303, 304) durch zwei parallele, in x-Richtung verlaufende Linien begrenzt sind und dort, wo sie in x-Richtung durch ein anderes, in y-Richtung benachbartes Feld (101, 102, 103, 104; 301, 302, 303, 304) fortgesetzt werden, eine schräg verlaufende Begrenzungslinie aufweisen, wobei sich die benachbarten Felder (101, 102, 103, 104; 301, 302, 303, 304) im Bereich der schräg verlaufenden Begrenzungslinien in x-Richtung überlappen.

12. Projektions-Mikrolithographiegerät nach einem der Ansprüche 1 bis 6, dadurch gekennzeichnet, daß die Bildfeldform mindestens ein kreissegmentähnliches Feld (401, 402; 501) umfaßt, welches an zwei gegenüberliegenden Seiten durch Kreisbögen gleichen Radiusses, deren Mittelpunkte in y-Richtung einen Abstand voneinander aufweisen, und an zwei gegenüberliegenden Seiten durch parallel zur y-Richtung verlaufende Geraden begrenzt ist.

13. Projektions-Mikrolithographiegerät nach Anspruch 12, dadurch gekennzeichnet, daß zwei kreisringsegmentähnliche Felder (401, 402) spiegelsymmetrisch zu der parallel zur x-Richtung verlaufenden Mittellinie angeordnet sind.

14. Projektions-Mikrolithographiegerät nach einem der vorhergehenden Ansprüche, dadurch gekennzeichnet, daß die die Bildfeldform erzeugende Einrichtung (16) mindestens einen Glasstab umfaßt.

15. Projektions-Mikrolithographiegerät nach Anspruch 14, dadurch gekennzeichnet, daß der Glasstab (161; 261) an seiner Austrittsstirnseite Verspiegelungen (162; 262) derart trägt, daß die von Verspiegelungen (162; 262) freie Austrittsstirnseite des Glasstabes (161; 261) der Bildfeldform zumindest annähernd geometrisch ähnlich ist.

16. Projektions-Mikrolithographiegerät nach Anspruch 15, dadurch gekennzeichnet, daß der Glasstab (261) an seiner Eintrittsstirnseite eine Verspiegelung (263) trägt, welche im wesentlichen nur den Querschnitt des in den Glasstab (261) eintretenden Lichtbündels freiläßt.

17. Projektions-Mikrolithographiegerät nach einem der Ansprüche 14 bis 16, dadurch gekennzeichnet, daß die die Bildfeldform erzeugende Einrichtung (16) eine Mehrzahl von Glasstäben (16a, 16b, 16c, 16d) umfaßt, deren Querschnitte so gewählt und die so angeordnet sind, daß ihre Austrittsstirnflächen ein der Bildfeldform zumindest annähernd geometrisch ähnliches Muster bilden.

18. Projektions-Mikrolithographiegerät nach einem der Ansprüche 14 bis 17, dadurch gekennzeichnet, daß eine Einrichtung vorgesehen ist, welche die räumliche Verteilung der Intensität des Lichtes, welches die die Bildfeldform erzeugende Einrichtung (16; 670) verläßt, vergleichmäßigt.

19. Projektions-Mikrolithographiegerät nach Anspruch 18, dadurch gekennzeichnet, daß die Einrichtung ein Graufilter ist.

20. Projektions-Mikrolithographiegerät nach Anspruch 18, dadurch gekennzeichnet, daß die Einrichtung eine verstellbare Blende ist.

21. Projektions-Mikrolithographiegerät nach einem der Ansprüche 14 bis 20, dadurch gekennzeichnet, daß die Beleuchtungseinrichtung ein diffraktives oder refraktives optisches Element (13) umfaßt, dessen optisch aktive Struktur so ausgebildet ist, daß die Eintritts-Stirnfläche(n) des oder der Glasstäbe (16a, 16b, 16c, 16d) weitgehend verlustfrei und gleichmäßig ausgeleuchtet ist (sind).

22. Projektions-Mikrolithographiegerät nach Anspruch 21, dadurch gekennzeichnet, daß die optisch aktive Struktur des diffraktiven oder refraktiven optischen Elements (13) eine Einheitszelle (20) mit optisch aktiven Feldern (21, 22, 23, 24) aufweist, deren Anordnung und Form der Anordnung und Form der Felder (1, 2, 3, 4) der Bildfeldform zumindest annähernd geometrisch ähnlich sind.

23. Projektions-Mikrolithographiegerät nach einem der Ansprüche 1 bis 10, dadurch gekennzeichnet, daß die die Bildfeldform erzeugende Einrichtung einen Prismen-Wabenkondensor (670) umfaßt, dessen Waben (671, 672) so eingerichtet und angeordnet sind, daß sie eine Bildfeldform erzeugen, die der gewünschten Bildfeldform zumindest annähernd geometrisch ähnlich ist.

24. Projektions-Mikrolithographiegerät nach einem der vorhergehenden Ansprüche, gekennzeichnet durch eine Maske (17), welche der Bildfeldform die exakte Gestalt gibt.
